# EUROPEAN PATENT APPLICATION

(11) **EP 1 589 570 A1**
(43) Date of publication of application: **26.10.2005**
(21) Application number: 04702046.6
(22) Date of filing: 14.01.2004
(51) Int. Cl.: H01L 21/60, H05K 3/34

(54) **SEMICONDUCTOR DEVICE AND PROCESS FOR PRODUCING THE SAME**

(30) Priority: 16.01.2003 JP 2003008026
(71) Applicant: SONY CORPORATION, Tokyo 141 (JP)
(72) Inventor: SENDA, Ayumi, (JP)
(74) Representative: Müller, Frithjof E.
(86) International application number: PCT/JP2004/000197
(87) International publication number: WO 2004/064142

(57) **Abstract**

When a semiconductor chip is mounted on a mount substrate by bonding bumps, bonding failure is caused by misalignment between the bumps.

Before a semiconductor chip having a plurality of bumps is mounted on a mount substrate (3) having a plurality of bumps (4) by flip chip bonding, a resist layer (5) having a thickness larger than that of the bumps (4) is formed on the mount substrate (3) with the bumps. By patterning the resist layer (5), projecting guides (5A) of semicircular cross section are formed on the mount substrate (3) so as to protrude near the bumps (4) and from a surface on which the bumps (4) are provided, and to have guide faces (curved faces) pointing toward the bumps (4).

## Description

### Technical Field

The present invention relates to a semiconductor-device production method suitably used to mount a semiconductor chip on a mount substrate by bonding bumps, and to a semiconductor device produced by the production method.

### Background Art

At present, SIPs (System in Package), which are obtained by combining a plurality of LSI (Large Scale Integration) devices, such as a CPU (central processing unit) and a memory, into one package, are known as a type of package for a high-performance semiconductor device. Some SIPs adopt a package form in which a plurality of semiconductor chips are mounted on a common mount substrate (interposer). Some other SIPs adopt, as a mount substrate, a semiconductor chip having a diameter larger than that of a semiconductor chip to be mounted thereon (chip-on-chip SIPs).

As a method for mounting a semiconductor device by using such an SIP package form, flip chip bonding has recently been practically available in order to increase the number of pins and to reduce the pitch. In flip chip bonding, bumps (metal projections) are formed on an electrode of a semiconductor chip, and the semiconductor chip is mounted on a mount substrate with the bumps disposed therebetween. Therefore, methods for forming and bonding the bumps are important.

In flip chip bonding, a semiconductor chip having a plurality of bumps is sometimes mounted on a mount substrate similarly having a plurality of bumps by a flip chip bonder. Semiconductor packages, such as SIPs, having such a mount structure are smaller and thinner and operate at higher speed with lower power consumption than normal packages using an organic substrate. Furthermore, the SIPs are more advantageous, for example, in cost, development TAT (Turn Around Time), and operation speed than SOCs (System on Chip) which are obtained by integrating functions of a CPU and a memory in one high-performance chip (e.g., a DRAM/logic LSI chip). Therefore, the SIPs are widely applicable not only to small and light portable electronic devices, but also to all electronic devices.

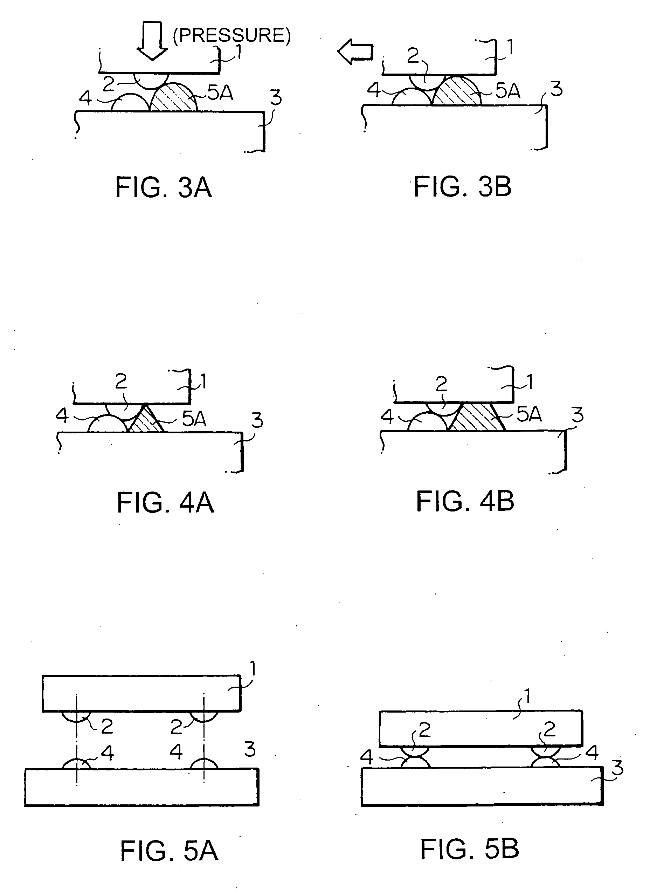

Figs. 5A and 5B are views explaining a conventional semiconductor-device production method. First, as shown in Fig. 5A, bumps 2 are formed on an electrode of a semiconductor chip 1, and bumps 4 are also formed on an electrode of the corresponding mount substrate 3. The mount substrate 3 is fixed on an unshown stage, and the semiconductor chip 1 is held by being sucked by an unshown vacuum chuck. The semiconductor chip 1 is then placed above the stage so as to face the mount substrate 3. In this case, the bumps 2 of the semiconductor chip 1 and the bumps 4 of the mount substrate 3 are aligned, for example, by image recognition using bumps and patterns.

Subsequently, as shown in Fig. 5B, the bumps 2 of the semiconductor chip 1 are brought into contact with the bumps 4 of the mount substrate 3 by moving the vacuum chuck down. In this contact state, the semiconductor chip 1 is pressed downward by the vacuum chuck, and the bumps 2 and 4 are bonded by being heated at a predetermined temperature.

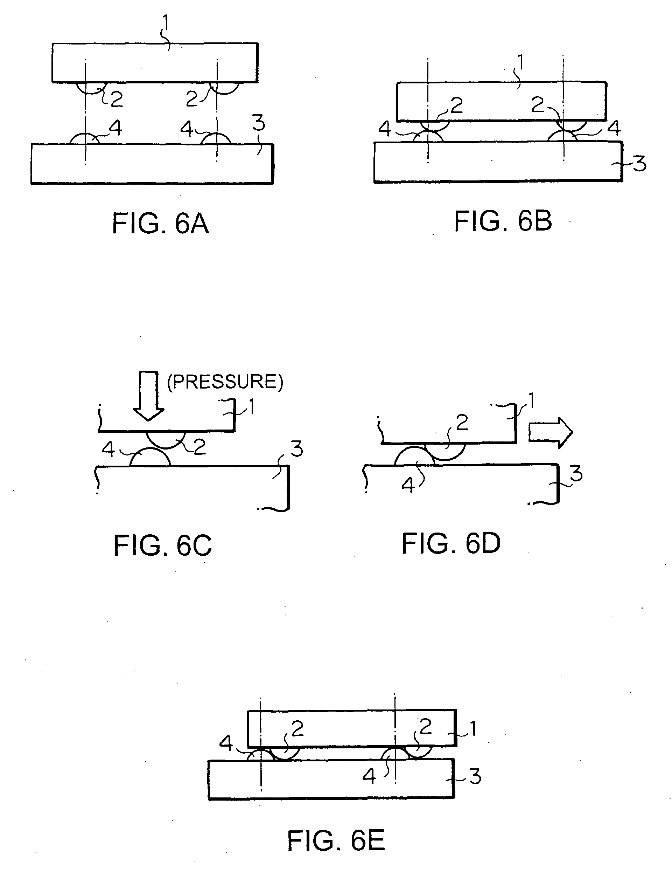

Conventionally, alignment between the semiconductor chip 1 and the mount substrate 3 is checked by using, for example, a dummy sample so that the semiconductor chip 1 and the mount substrate 3 are not misaligned. However, for example, when the bumps 2 and 4 are ball-shaped, a slight misalignment greatly affects bondability of the bumps and the electrical characteristics of the semiconductor device. That is, in a case.in which the centers of the bumps 2 on the semiconductor chip 1 are not aligned with the centers (shown by one-dot chain lines) of the bumps 4 on the mount substrate 3, as shown in Fig. 6A, when the bumps 2 and 4 are pressed in contact with each other, they slip away from each other, as shown in Figs. 6B and 6C, and the misalignment between the semiconductor chip 1 and the mount substrate 3 increases.

Consequently, as shown in Figs. 6D and 6E, the semiconductor chip 1 is displaced in the plane direction of the mount substrate 3 (in the right-left direction in the figure). Therefore, the positional relationship between the bumps 2 and 4 is seriously disrupted, and the bumps 2 and 4 are bonded in this state. As a result, at bump bonding portions between the semiconductor chip 1 and the mount substrate 3, the resistance increases because of reduction of the contact area. In some cases, open failure or shortcircuit failure may occur.

For example, Patent Document 1 (Japanese Unexamined Patent Application Publication No. 2000-100868 (paragraphs 0022 to 0027, Fig. 3)) describes "a production method for a semiconductor device". In the method, an insulating resin layer is formed on a wiring-layer forming surface of a wiring board, tapered openings are formed in the insulating resin layer, solder layers are formed inside the openings, ball-shaped metal bumps are formed on an aluminum electrode terminal of a semiconductor chip, the metal bumps are heated in pressed contact with the solder layers in the openings of the insulating resin layer so as to be put into the melted and softened solder layers, and bonding portions between the metal bumps of the semiconductor chip and wiring pads are coated with and sealed by the insulating resin layer by bringing the upper surface of the softened insulating resin layer into tight contact with an electrode-terminal surface of the semiconductor chip.

However, in the production method described in the above Patent Document 1, when a metal bump of the semiconductor chip is put in a solder layer in an opening of the insulating resin layer, since the insulating resin layer is softened by heating, if the metal bump is relatively offset from the opening, it is stuck in the insulating resin layer while extending the opening. Therefore, the opening of the insulating resin layer does not serve a function of preventing misalignment with the metal bump. Furthermore, in the production method described in the above Patent Document 1, bumps are not bonded in contact with each other. Accordingly, the production method described in the above Patent Document 1 cannot solve the problem to be solved by the present invention, that is, bonding failure caused by the misalignment between the bumps 2 and 4 when the semiconductor chip 1 is mounted on the mount substrate 3 by flip chip bonding, as described above.

### Disclosure of Invention

In a semiconductor-device production method according to the present invention, before a semiconductor chip having a plurality of bumps is mounted on a mount substrate having a plurality of bumps by flip chip bonding, projecting guides are formed on at least one of the semiconductor chip and the mount substrate so as to protrude near the bumps and from a surface on which the bumps are provided and to have guide faces pointing toward the bumps.

In the above semiconductor-device production method, when the semiconductor chip is mounted on the mount substrate, for example, projecting guides are formed on the mount substrate beforehand. Even when the bumps are slightly misaligned, the bumps of the semiconductor chip touch the guide faces of the projecting guides during bump bonding. The misalignment between the bumps is corrected by applying pressure in this state.

### Brief Description of the Drawings

Fig. 1 is an explanatory view showing a specific example of a semiconductor-device production method according to an embodiment of the present invention (No. 1).
Figs. 2A to 2C are explanatory views showing the specific example of the semiconductor-device production method according to the embodiment of the present invention (No. 2) .
Figs. 3A and 3B are explanatory views showing the specific example of the semiconductor-device production method according to the embodiment of the present invention (No. 3).
Figs. 4A and 4B are views showing another example of a cross-sectional shape of a projecting guide.
Figs. 5A and 5B are explanatory views showing a conventional semiconductor-device production method.
Figs. 6A to 6E are explanatory views showing a problem of the conventional method.

### Best Mode for Carrying Out the Invention

An embodiment of the present invention will be described in detail below with reference to the drawings.

In a semiconductor-device production method according to the present invention, flip chip bonding for electrically connecting electrodes of a semiconductor chip and a mount substrate by bonding bumps is adopted to mount the semiconductor chip on the mount substrate. A specific procedure of the method will be described below.

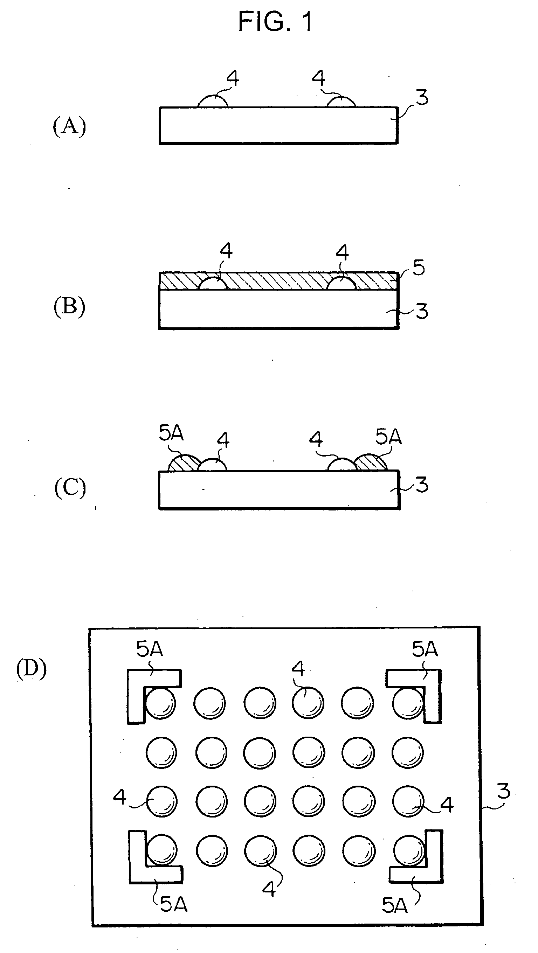

Figs. 1 to 3B are explanatory views showing a specific example of a semiconductor-device production method according to an embodiment of the present invention. In the description of this embodiment, components similar to those of the above-described conventional art are denoted by the same reference numerals.

First, as shown in Fig. 1(A), a plurality of bumps 4 are formed on a chip mount surface of a mount substrate 3 on which a semiconductor chip is to be mounted. Each of the bumps 4 is a metal bump made of a metal that is not melted at a heating temperature during bump bonding, for example, solder, and is formed like a ball on an electrode pad provided on the chip mount surface of the mount substrate 3. While bumps are typically formed by plating a wafer, they may be formed by, for example, dipping, or reflowing after plating.

Next, a resist layer 5 is formed by coating the entire chip mount surface of the mount substrate 3 with a resist, as shown in Fig. 1(B). As the resist material, a material that becomes harder than the bumps at the heating temperature during bump bonding that will be described later, for example, a thermosetting resin such as epoxy resin or phenol resin. The coating thickness of the resist is adjusted so that the thickness of the resist layer 5 relative to the chip mount surface of the mount substrate 3 is larger than the height of the bumps 4 in a finished state after the resin is set. More preferably, the coating thickness of the resist is adjusted so that the thickness of the resist layer 5 is equal to or smaller than a prescribed gap between an unshown semiconductor chip and the mount substrate 3 in a finished state after the resin is set. The thickness of the resist layer 5 described herein corresponds to the height of projecting guides 5A that will be described later.

Subsequently, projecting guides 5A that are L-shaped (hook-shaped) in plan view are formed near the bumps 4 provided at four corners on the outermost periphery by patterning the resist layer 5 on the mount substrate 3 into a desired shape, as shown in Figs. 1(C) and 1(D). Patterning of the resist layer 5 is performed by first exposing the resist layer 5 by ultraviolet radiation using an unshown photomask, removing an unnecessary resist material by development, and then thermally setting a resist material remaining on the mount substrate 3. When the projecting guides 5A obtained by this patterning is rectangular in cross section, they cannot serve a desired guide function. Therefore, the projecting guides 5A are shaped into a desired form, for example, by sputtering. As an example, the projecting guides 5A are shaped to be substantially semicircular in cross section.

Consequently, the projecting guides 5A are formed on the chip mount surface of the mount substrate 3 to protrude from the surface on which the bumps 4 are provided. Since the projecting guides 5A are shaped to be substantially semicircular in cross section, as described above, curved faces pointing toward the bumps 4 serve as guide faces provided along oblique lines (not shown) at an obtuse angle to the bump forming surface of the mount substrate 3 (substantially the same as the chip mount surface). The guide faces serve as positioning guide faces that allow bumps 2 of a semiconductor chip 1, which will be described later, to be reliably bonded to the bumps 4 of the mount substrate 3 when the bumps are bonded (bump bonding).

When forming the projecting guides 5A having such guide faces, the height of the projecting guides 5A is larger than the height of the bumps 4 because the coating thickness of the resist is adjusted in the above process before patterning so that the thickness of the resist layer 5, from which the projecting guides 5A are made, is larger than the height of the bumps 4 in a finished state after resin setting.

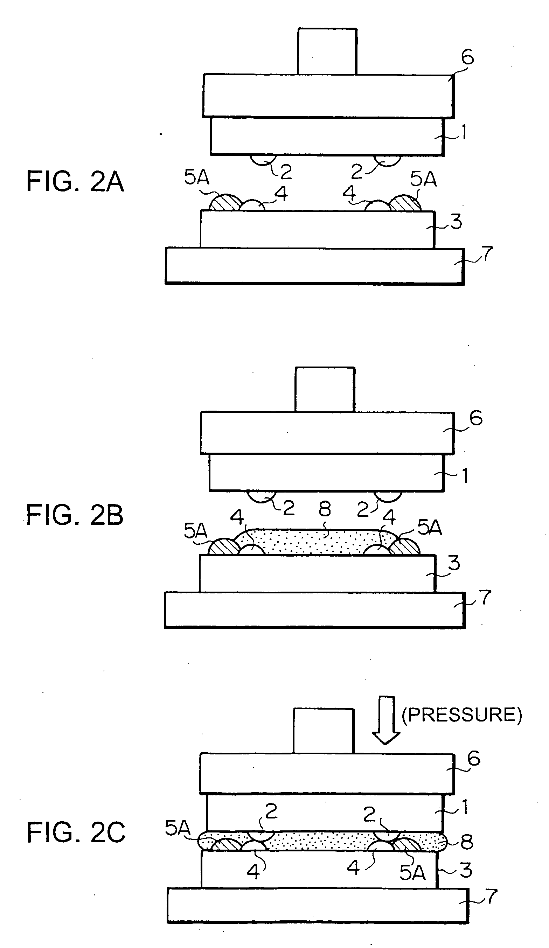

Subsequently, as shown in Fig. 2A, a semiconductor chip 1 on which bumps 2 are formed beforehand is sucked and held face down by a vacuum chuck 6, and the mount substrate 3 on which the projecting guides 5A are formed, as described above, is fixed onto a stage 7 of a flip chip bonder. Prior to fixing the mount substrate 3 on the stage 7, the position of the stage 7 is adjusted (coarse adjustment) by using a dummy sample. After the mount substrate 3 is placed on the stage 7, the semiconductor chip 1 held by the vacuum chuck 6 is placed above the stage 7 so as to face the mount substrate 3, and relative positioning (fine adjustment) of the semiconductor chip 1 and the mount substrate 3 is performed in this state by an image recognition system of the flip chip bonder. The positioning may be performed by horizontally moving the stage 7 or horizontally moving the vacuum chuck 6.

Next, as shown in Fig. 2B, sealing underfill 8 is applied onto the chip mount surface of the mount substrate 3 by a dispenser or the like. An application region of the underfill 8 is limited to a region surrounding the bumps 4 provided on the outermost periphery of the chip mount surface of the mount substrate 3. In this case, instead of the underfill 8, an adhesive film, such as an ACF (Anisotropic Conductive Film) or an NCF (Non-Conductive Film), may be stuck beforehand on the chip mount surface of the mount substrate 3.

Subsequently, as shown in Fig. 2C, the bumps 2 on the semiconductor chip 1 are brought into contact with the bumps 4 on the mount substrate 3 by moving the vacuum chuck 6 down. In this case, the underfill 8 applied on the mount substrate 3 is pressed by the semiconductor chip 1, and is thereby filled between the semiconductor chip 1 and the mount substrate 3.

Even when the bumps 2 and 4 are slightly misaligned when being brought into contact with each other, the bumps 2 of the semiconductor chip 1 touch the inner curved faces (guide faces) of the projecting guides 5A, as shown in Fig. 3A, and the vacuum chuck 6 presses the semiconductor chip 1 in the direction of the arrow in this state. For this reason, the bumps 2 slip down on the curved faces of the projecting guides 5A, and the semiconductor chip 1 held by the vacuum chuck 6 is thereby shifted to the left (in the direction of the arrow in the figure), that is, in a direction such as to reduce misalignment between the bumps 2 and 4 (a direction such as to correct the misalignment), as shown in Fig. 3B.

As a result, when the semiconductor chip 1 is mounted on the mount substrate 3, it is possible to effectively correct misalignment between the bumps 2 and 4, and to enhance stability of bump bonding. Moreover, since alignment adjustment using a dummy sample does not require a high accuracy, the adjustment time can be substantially reduced, and productivity can be enhanced. Incidentally, in a semiconductor device obtained by the above-described production method, the projecting guides 5A are formed on the mount substrate 3.

By setting the height of the projecting guides 5A to be equal to the prescribed gap between the semiconductor chip 1 and the mount substrate 3, the projecting guides 5A can function as spacers between the semiconductor chip 1 and the mount substrate 3. Consequently, the gap between the semiconductor chip 1 and the mount substrate 3 can be precisely controlled by using the height of the projecting guides 5A as a parameter.

While the projecting guides 5A are respectively provided near the bumps 4 at the four corners on the outermost periphery of the mount substrate 3 in the above embodiment, the layout and number of the projecting guides 5A may be changed arbitrarily. Projecting guides 5A similar to the above may be formed on the semiconductor chip 1, or projecting guides 5A similar to the above may be formed on both the semiconductor chip 1 and the mount substrate 3. When the projecting guides 5A are formed on both the semiconductor chip 1 and the mount substrate 3, it is necessary to give consideration so that the projecting guides 5A do not interfere with each other during bump bonding.

While the cross section of the projecting guides 5A is semicircular in the above embodiment, for example, it may be triangular, as shown in Fig. 4A, or may be trapezoidal, as shown in Fig. 4B. When the projecting guides 5A have a cross-sectional shape shown in Fig. 4A or 4B, inclined faces provided along an oblique line at an obtuse angle to the bump forming surface are formed to function as guide faces during bump bonding.

### Industrial Applicability

As described above, according to the present invention, when a semiconductor chip having a plurality of bumps is mounted on a mount substrate having a plurality of bumps by flip-chip bonding, projecting guides are formed beforehand on at least one of the semiconductor chip and the mount substrate so as to protrude near the bumps and from a surface on which the bumps are provided, and to have guide faces pointing toward the bumps. Therefore, during bump bonding, misalignment between the bumps can be corrected by the guide faces of the projecting guides, and a stable bonding state can be thereby obtained.

## Claims

1. A semiconductor-device production method wherein, before a semiconductor chip having a plurality of bumps is mounted on a mount substrate having a plurality of bumps by flip chip bonding, projecting guides are formed on at least one of the semiconductor chip and the mount substrate so as to protrude near the bumps and from a surface on which the bumps are provided, and to have guide faces pointing toward the bumps.

2. The semiconductor-device production method according to claim 1, wherein the guide faces of the projecting guides are inclined faces or curved faces disposed along oblique lines at an obtuse angle to the surface on which the bumps are provided.

3. The semiconductor-device production method according to claim 1, wherein the projecting guides are provided near the bumps disposed at four corners on the outermost periphery of the semiconductor chip or the mount substrate.

4. The semiconductor-device production method according to claim 1, wherein the projecting guides are made of a material that becomes harder than the bumps at a heating temperature during bump bonding.

5. The semiconductor-device production method according to claim 1, wherein the projecting guides are provided near the bumps so as to be substantially L-shaped in plan view.

6. The semiconductor-device production method according to claim 1, wherein the projecting guides are formed so that the height thereof is larger than the height of the bumps disposed near the projecting guides.

7. The semiconductor-device production method according to claim 6, wherein the projecting guides are formed so that the height thereof is substantially equal to or smaller than a prescribed gap between the semiconductor chip and the mount substrate.

8. A semiconductor device wherein a semiconductor chip having a plurality of bumps is mounted on a mount substrate having a plurality of bumps by flip chip bonding, and wherein projecting guides are provided on at least one of the semiconductor chip and the mount substrate so as to protrude near the bumps and from a surface on which the bumps are provided, and to have guide faces pointing toward the bumps.
